(19)

Europäisches
Patentamt
European
Patent Office
Office européen
des brevets

(11)  EP 2 720 523 B1

(12)  **EUROPEAN PATENT SPECIFICATION**

(45) Date of publication and mention
of the grant of the patent:
**31.01.2018   Bulletin 2018/05**

(51) Int Cl.:
**H05K 7/20** (2006.01)

(21) Application number: **12187864.9**

(22) Date of filing: **09.10.2012**

(54) **Electronic device**

Elektronische Vorrichtung

Dispositif électronique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**16.04.2014   Bulletin 2014/16**

(73) Proprietor: **FUJITSU LIMITED
Kawasaki-shi,
Kanagawa 211-8588 (JP)**

(72) Inventor: **Albornoz, Jose
Hayes, Middlesex UB4 8FE (GB)**

(74) Representative: **Hutchison, James
Haseltine Lake LLP
300 High Holborn
London, Greater London WC1V 7JH (GB)**

(56) References cited:
**DE-A1- 3 740 357        US-A1- 2005 076 660
US-A1- 2009 178 436       US-A1- 2010 175 851
US-B1- 7 394 655**

**Description**

The present invention lies in the field of electronic devices. In particular, the present invention relates to the cooling of electronic devices and the utilisation of waste heat generated by operation of a component within an electronic device.

Electronic devices, both on their own and in systems of electronic devices, consume electrical power and generate heat. To prevent overheating of such electronic devices, and to maintain electronic devices and their components at optimum operating temperatures, cooling systems are provided to remove the heat rejected by the devices. Such cooling systems consume energy. The heat is transferred away from the devices and rejected by the cooling system as 'low grade heat', that is, at a temperature which is generally above that of the surroundings, but is difficult to utilise. For example, in data centres, cooling systems typically account for approximately one third of all energy consumed.

United States patent publication US7,394,655B1 discloses active electrical components within a housing that contains an absorptive cooler. The absorptive cooler is used to cool active electrical components, such as central processors or other heat-sensitive components. Heat produced by electronic components is used to provide heat to the absorptive cooler.

United States patent publication US2005/0076660A1 discloses a cooling apparatus for a system which generates heat therein, the cooling apparatus includes a chamber for receiving at least a portion of the heat, the chamber containing a refrigerant therein, a condenser for receiving the refrigerant having been heated in the chamber, the refrigerant being pressurized and cooled in the condenser, and at least one coil coupled to the condenser and leading to a region to be cooled. The at least one coil includes a first portion coupled to the condenser, a second portion downstream from the first portion, and a third portion downstream of the second portion. The second downstream portion contains an orifice for free expansion to cause cooling of the region, and the third downstream portion leads from the region to be cooled back to the chamber.

United States patent publication US 2010/0175851A1 discloses a passive heat sink for cooling an electronic component such as a high-performance processor. The heat sink includes a shell with a surface that is positionable adjacent a heat generating surface of the electronic component. A generator compartment is provided within the shell with a generator vessel for containing an absorbent, and the generator compartment is maintained at a pressure lower than ambient. The generator compartment conducts heat away from the electronic component to the absorbent in the generator vessel. An absorber compartment, at a pressure lower than the generator compartment, is provided within the shell above the generator compartment, and, in use, an absorption refrigeration cycle contained within the shell is activated by heat from the electronic component. A bubble pump moves absorbent from the generator compartment to the absorber compartment.

German patent publication DE3740357 A1 discloses a passive sorption cooling system in which the lost heat produced in a room, in the event of high ambient temperatures, is stored temporarily (buffered) in a heat reservoir (heat accumulator). Storage is effected by sorption, by means of a sorbent, of a refrigerant evaporating in an evaporator. In the event of low ambient temperatures, the lost heat is used to drive out the refrigerant. The refrigerant driven out is liquefied in a condenser arranged outside the room and, under the influence of gravity, flows back to the evaporator. Cooling of shelter operating locations.

The present invention is defined by the appended independent claims, to which reference should now be made. Specific embodiments are defined in the dependent claims.

Embodiments of the present invention include an electronic device comprising: a housing; an electronic component housed within the housing; and a generator connectable within a vapour-absorption-refrigeration-cycle and being housed within the housing and configured to use heat generated by operation of the electronic component to evaporate refrigerant from an absorbing medium in the vapour-absorption-refrigeration-cycle; an evaporator, the evaporator being connectable within the vapour-absorption-refrigeration cycle and disposed within the housing; a condenser and an absorber; characterised by the condenser and the absorber being connectable within the vapour-absorption-refrigeration-cycle and disposed outside of the housing; a vapour absorption system being connectable within the vapour-absorption-refrigeration-cycle and including the generator and the absorber; wherein the generator and the absorber are in fluid communication with one another via a first channel having a fluid pressure increasing means configured to cause a pressure increase in fluid flowing through the first channel, and a second channel having a fluid pressure decreasing means configured to cause a pressure decrease in fluid flowing through the second channel; and wherein the absorber is configured to receive the refrigerant from the vapour-absorption-refrigeration-cycle as a vapour, to absorb the refrigerant into an absorbing medium, and to provide the absorbing medium and absorbed refrigerant to the generator via the first channel; wherein the generator is configured to receive the absorbing medium and absorbed refrigerant, to use heat from the electronic component to evaporate the refrigerant from the absorbing medium, to provide the evaporated refrigerant to the vapour-absorption-refrigeration-cycle, and to provide the absorbing medium to the absorber via the first channel; and a pressure controller, configured to monitor the temperature of the electronic component, and to control the fluid pressure increasing means to set the pressure of the fluid provided to the generator so that the boiling point of the refrigerant in the fluid provided to the generator is below the monitored temperature of the electronic component and within a predetermined margin of said temperature.

Advantageously, embodiments of the present invention exploit refrigeration technologies which employ a heat source to drive a thermodynamic cooling cycle to provide a device which is configured to allow high-grade heat generated by operation of an electronic component to be harvested and used to drive a refrigeration cycle.

Electronic components within a housing generate heat in operation, in particular, electronic components act as heat sources, transferring electrical energy into heat energy. The heat energy so generated must be removed from the housing to prevent the temperature within the housing getting too high. If the temperature is allowed to increase too far, detrimental effects include a reduction in efficiency of the electronic component or other apparatus within the housing, a risk of damage to the electronic component or other apparatus within the housing, and a risk of fire. Therefore, cooling systems are implemented within electronic devices to transfer heat away from the housing. Furthermore, in environments in which there are a plurality of electronic devices all generating waste heat, there may be a further cooling system to remove the waste heat from the enclosure in which the electronic devices are situated. An example of such an environment is a data centre in IT, wherein each server may have a cooling system, such as a fan blowing air over components, and the data centre itself may have a water-based cooling system or air conditioning system having a chiller to remove the waste heat removed from the servers. However, cooling systems require work to be done in order to realise the transfer of heat away from an electronic device and/or away from an enclosure, and hence cooling systems consume energy.

The inventors of the present invention have realised that, contrary to the established view of electronic devices as sources of low grade waste heat, the heat produced at an electronic component within an electronic device is actually suitable for use as a heat source as part of a vapour-absorption-refrigeration-cycle. Advantageously, by using some of the heat generated by operation of an electronic component to drive a cooling cycle, the waste heat can be used to drive a cooling effect, thus energy consumption by cooling systems external to the device is reduced. The heat used in a cooling cycle may be put to use cooling the electronic device or the enclosure in which it is situated, which cooling effect reduces the amount of cooling that is required from other, external cooling systems, and hence reduces the energy consumption by those other cooling systems. Of course, the energy consumption by the cooling systems in the above discussion is taken to be the consumption of energy from sources other than the heat generated by the electronic component.

In summary, embodiments of the present invention result in a significant reduction in the amount of energy required to run cooling equipment to remove the heat generated by operation of an electronic component within an electronic device housing.

The generator is connectable within a vapour-absorption-refrigeration-cycle, which is a type of refrigeration cycle in which a vapour absorption cycle is used to increase the temperature and pressure of a refrigerant, so that the refrigerant can be condensed, expanded, and evaporated, before re-introduction to the vapour absorption cycle as a vapour. The remaining elements of the vapour absorption cycle include an absorber; wherein the generator and the absorber are in fluid communication with one another via a first channel having a fluid pressure increasing means configured to cause a pressure increase in fluid flowing through the first channel, and a second channel having a fluid pressure decreasing means configured to cause a pressure decrease in fluid flowing through the second channel; and wherein the absorber is configured to receive the refrigerant from the vapour-absorption-refrigeration-cycle as a vapour, to absorb the refrigerant into an absorbing medium, and to provide the absorbing medium and absorbed refrigerant to the generator via the first channel; and wherein the generator is configured to receive the absorbing medium and absorbed refrigerant, to use heat from the electronic component to evaporate the refrigerant from the absorbing medium, to provide the evaporated refrigerant to the vapour-absorption-refrigeration-cycle, and to provide the absorbing medium to the absorber via the first channel.

The vapour absorption cycle is taken to mean a system of components configured to establish a vapour-absorption-cycle within a vapour-absorption-refrigeration cycle. As detailed above, those components include a generator configured to use heat energy from an electronic component to evaporate refrigerant from a mixture of absorbing medium and refrigerant, an absorber configured to mix refrigerant and absorbing medium together, a fluid pressure increasing means configured to increase the pressure of the mixture as it passes from the absorber to the generator, and a pressure decreasing means configured to cause a pressure decrease in the absorbing medium as it passes from the generator to the absorber. The generator may be, for example, an evaporator, which may be in direct contact with the electronic component or casing of the electronic component. The generator is arranged to enable heat transfer from the electronic component to the mixture of absorbing medium and refrigerant, possibly via various casings and other structural elements, which may preferably be composed of thermally conductive materials to facilitate heat transfer to the mixture. The generator may therefore include a conduit or piping of thermally conductive material through which the mixture flows, and/or a form of chamber or receptacle arranged to allow separation of vaporised refrigerant from the absorbing medium. The pressure increasing means may be, for example, a pump. The pressure decreasing means may be, for example, a regulation valve. The absorber may be, for example, a chamber configured to receive refrigerant in vapour form, and a system of sprays configured to spray the vapour with absorbing medium to produce the mixture. The refrigerant may be, for example, water, and the absorbing may be a hygroscopic solution. The elements other than the generator may be provided as part of the electronic device, or may be provided separately and subsequently connected to the generator.

The vapour absorption cycle effectively forms a sub-cycle within a refrigeration cycle, and by virtue of including a vapour absorption cycle that refrigeration cycle is referred to as a vapour-absorption-refrigeration-cycle. The further elements of the vapour-absorption-refrigeration-cycle may be included in embodiments, or may be separate and connectable to at least the generator of invention embodiments. The refrigeration cycle comprises further elements including: a condenser, a condensed refrigerant pressure decreasing means, and an evaporator, all connectable within the vapour-absorption-refrigeration cycle, wherein: the condenser is configured to receive the evaporated refrigerant from the generator and to transfer heat away from the refrigerant, causing the refrigerant to condense; the condensed refrigerant pressure decreasing means is configured to receive the condensed refrigerant from the condenser at a first pressure, and to provide the condensed refrigerant to the evaporator at a second pressure, the second pressure being lower than the first pressure; the evaporator is configured to receive the condensed refrigerant provided by the condensed refrigerant pressure decreasing means, to use heat from the environment surrounding the evaporator to evaporate the condensed refrigerant, and to provide the refrigerant as a vapour to the absorber.

The generator is configured to provide evaporated refrigerant to the condenser at a pressure which enables the refrigerant to condense at the temperature of the condenser (or the environment immediately surrounding the condenser). Therefore, the condenser is arranged to enable heat transfer from the evaporated refrigerant to its immediate surroundings, and hence to cause the refrigerant to condense. The condenser may therefore be realised by a conduit or piping of thermally conductive material, possibly coiled or otherwise arranged to allow sufficient transfer of energy away from the refrigerant to cause condensation. The condensed refrigerant pressure decreasing means may be realised by an expansion valve.

The expansion valve is configured so that the condensed refrigerant is provided to the evaporator at a pressure which enables the refrigerant to boil (evaporate) at the temperature of the evaporator (or the environment immediately surrounding the evaporator). Therefore, the evaporator is arranged to enable heat transfer from its immediate surroundings to the received condensed (liquid) refrigerant, and hence to cause the refrigerant to boil/evaporate. The evaporator may therefore be realised by a conduit or piping of thermally conductive material, possibly coiled or otherwise arranged to allow sufficient transfer of energy to the refrigerant to cause evaporation.

Of course, the purpose of a refrigeration cycle is to use a refrigerant to move heat from one location to another. Elements of the vapour-absorption-refrigeration-cycle at which heat is transferred away from the refrigerant include the absorber and the condenser. Therefore, if transfer of heat away from the housing is desirable, it may be that the condenser and/or the absorber are disposed outside of the housing.

Depending on the implementation details of an embodiment, it may be that a water-based free cooling system is included to remove waste heat from the refrigeration cycle. Therefore, it may be that the condenser and/or the absorber are configured so that waste heat can be removed from them by a stream of water. The condenser and/or absorber thus release heat into a stream of water which is delivered to a dry cooler or cooling tower. Alternative configurations are also possible, for example the condenser and/or absorber may be disposed in a flow path of cooled air from an air handling unit. A water-based free cooling system as a heat removal medium is advantageous as it obviates the requirement for a conventional chiller plant. The reduction in power consumption achieved by operating a water-based free cooling system in the place of a chiller plant is significant, and hence results in a significant operational cost reduction, both in terms of financial cost and $CO_2$ or energy cost.

Furthermore, should it be desirable to remove heat from the housing, then it may be that the evaporator is disposed within the housing. Of course, with this arrangement, embodiments of the present invention enable a particularly significant reduction in the energy consumed by cooling systems, since not only does the use of heat from the electronic component by the generator result in a cooling effect within the housing, but the waste heat that is generated is concentrated at the absorber and condenser, and hence is in a form suitable for removal by a water-based free cooling system. Thus, the waste heat (which must be removed by other cooling systems which may consume energy) can be removed without needing to operate a chiller, which results in significant energy savings in an implementation such as a data centre where a plurality of devices embodying the present invention are contained in a single facility.

The cooling effect of the evaporator may be enhanced, and the removal of waste heat from the housing may be facilitated, by a fan configured to force air over the evaporator. The device may be arranged such that air is drawn in by the fan from outside the housing, over the evaporator, circulated within the housing, and then expelled.

The selection of refrigerant will depend on implementation details including the temperatures of the environments in which the refrigerant will be evaporated and condensed in the refrigeration cycle. Advantageously, the embodiments of the present invention provide a refrigeration cycle which, for many implementations, can provide a desired cooling effect via the use of water as a refrigerant. This is advantageous because water is cheap, plentiful (and hence easy to replace), and does not have harmful environmental effects associated with other refrigerants. A complementary absorbing medium in such cases is a hygroscopic salt solution. Hence, it may be that in embodiments of the present invention the refrigerant includes water, and the absorbing medium includes hygroscopic salt.

As we have discussed previously, in the vapour-absorption-refrigeration-cycle, waste heat is generated at the condenser and the absorber. Of course, it is desirable to reduce the amount of waste heat produced, and hence to reduce the load imposed on cooling systems external to the device. Within the vapour absorption cycle, it may be possible to further reduce the amount of waste heat at the absorber by providing a heat exchanger configured to transfer heat between fluid flowing through the first channel and fluid flowing through the second channel. Thus, the hot absorbing medium on its way to the absorber, produced as a result of heating the absorbing medium/refrigerant mixture in the generator, transfers some of its heat to the mixture on its way to the generator. The waste heat at the absorber is therefore reduced. Of course, the vapour absorption cycle is still effective in removing heat from the electronic component since a large proportion of the heat energy is transferred in the evaporation process itself, and not merely by the heating of the mixture to the boiling point of the refrigerant. In addition, the heat exchanger has the effect of increasing the temperature of the medium that moves from the absorber to the generator, thus reducing the heat input required by the generator. In summary, the heat exchanger may be desirable in some implementations in dependence upon the specific thermodynamic considerations of the device.

Embodiments of the present invention may be implemented in arrangements in which the power consumption rate and hence the temperature of the electronic component is more or less fixed, as are the temperatures of the environments surrounding the evaporator and the condenser. However, in many implementations, there may be significant changes in the ambient temperature and in the load placed on the electronic component. Indeed, changes in load on other components within the housing may also affect the temperature of the electronic component or the environment around the evaporator. The pressure of a fluid affects its boiling point, therefore, controlling the pressure of fluids through different sections of the vapour-absorption-refrigeration-cycle provides a means for ensuring that the refrigerant will boil in the generator, condense in the condenser, and evaporate in the evaporator. For implementations in which environmental and operating temperatures may vary throughout a range of temperatures, the electronic device may further comprise a pressure controller, configured to monitor the temperature of the one of the electronic component, and to control the fluid pressure increasing means to set the pressure of the fluid provided to the generator so that the boiling point of the refrigerant in the fluid provided to the generator is below the monitored temperature of the one of the electronic component and within a predetermined margin of said temperature.

Alternatively or additionally, the electronic device may also comprise a second pressure controller, configured to monitor the temperature of the environment surrounding the evaporator, and to control the condensed refrigerant pressure decreasing means to set the pressure of the condensed refrigerant entering the evaporator so that the boiling point of the condensed refrigerant entering the evaporator is below the monitored temperature of the environment surrounding the evaporator and within a predetermined margin of said temperature.

Either or both of the pressure controller and the second pressure controller may be realised in hardware or software configurations. For example, the function of the pressure controller and the second pressure controller may be realised by a program or application running on the operating system of a server embodying the present invention.

Embodiments of the present invention aim to reduce the energy required to cool electronic devices. An area of technology in which power consumption of cooling systems is a significant contribution to the overall running cost of the technology is server data centres, for example, of the sort provided as a resource in cloud computing. Among the many sub-systems found in data centres, the cooling infrastructure is particularly important since it accounts for almost a third of the total power consumption in most facilities: therefore, a number of measures and techniques have been devised to reduce the energy consumption of data centre cooling systems. On the other hand, a data centre generates a great amount of waste heat which is usually rejected into the atmosphere. The present invention may be embodied in an arrangement in which the electronic device is a server, the housing is a server case, and the electronic component is a processor case containing one or more processors. Increasingly dense computer architectures are increasing the power dissipated per server or per server rack, to a point where conventional air-based cooling systems cease to be efficient or even effective. Embodiments of the present invention provide a mechanism for harvesting heat directly from the processors of servers, hence obtaining useful high grade heat and ensuring server integrity and reliability. Furthermore, with the evaporator within the server case/chassis and the generator and absorber outside of the case/chassis, the waste heat generated by a server's processors provides cooling for other components within the server case/chassis thereby reducing the energy required to cool the data centre within which the server is situated.

In such embodiments, waste heat is harvested directly at a server's processors and ancillary chips (and other components within the processor case) to drive a miniaturised absorption cooler (wherein an 'absorption cooler' is an example of a vapour-absorption-refrigeration-cycle), which is in turn used to cool the other components in the server. The total heat removed by the absorption cooler is rejected as low grade heat by an absorber and a condenser, and can be rejected into the environment by a forced air cooling system or using a liquid coolant.

Computer servers are particularly effective embodiments of the present invention because it is possible to harvest heat from the server's processors and ancillary chips while maintaining a safe temperature within the case, in many servers the power dissipated by the processors accounts for most of the total power dissipated in the server, and the dissipated power levels and temperatures found within a server make possible and favourable the operation of a single-stage absorption cooler.

The precise layout of components within the server may vary between implementations, however, it is common in servers for a heat sink to be provided as a means for transferring heat away from the processor. For example, such a heat sink could be realised by fins over which air is forced to remove heat. In embodiments of the present invention, the generator itself may be provided as the heat sink for the processor chip. Hence, no fins or other heat sink is required, and the requirement to force air towards the processor chip is obviated.

Embodiments of the present invention also include a data centre comprising: an enclosure containing one or more servers embodying the present invention; and a cooling system configured to remove waste heat from said one or more servers. A data centre is a facility used to provide computer resources for remote access by client systems. A data centre enclosure may contain tens, hundreds, or thousands of servers, and hence the cooling requirements of the data centre is a significant design consideration. Advantageously, in a data centre embodying the present invention, the burden imposed on the cooling system by operation of servers within the data centre enclosure is reduced.

Preferred features of the present invention will now be described, purely by way of example, with reference to the accompanying drawings, in which:-

Figure 1 is a schematic diagram of a device embodying the present invention;
Figure 2 is a diagram of a server embodying the present invention;
Figure 3 illustrates an exemplary system for removing heat from the absorber and condenser in embodiments of the present invention; and
Figure 4 illustrates the arrangement of elements within a blade server embodying the present invention.

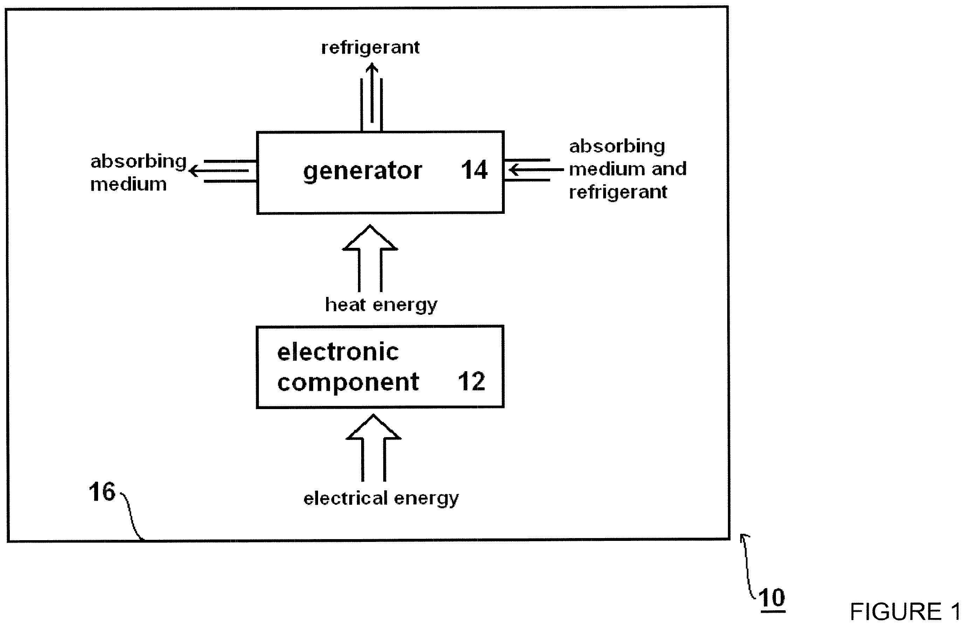

Figure 1 is a schematic representation of an embodiment. The electronic device 10 includes a housing 16, and an electronic component 12 and generator 14 within the housing.

The electronic component 12 may be any electronic component that, in operation, consumes electrical energy and hence generates heat energy. In certain embodiments it may be that a certain power consumption is required by the electronic component 12 in order to effectively drive the generator 14.

The electronic component 12 and the generator 14 are arranged so that the generator 14 can use heat energy from the electronic component 12 as a heat source in a process of evaporating refrigerant from a mixture of absorbing medium and refrigerant. For example, the generator 14 may be positioned with a thermally conductive surface in direct contact with the electronic component 12 or a casing of the electronic component 12 to enable heat generated by the electronic component 12 to be harvested for use in the evaporation. Alternatively, a heat transfer medium such as air or water may be used to transfer heat from the electronic component 12 to the generator 14. The generator 14 is connectable as part of a vapour-absorption-refrigeration-cycle, which is taken to mean a system of components configured to establish (when in use) a vapour-absorption-refrigeration-cycle. The generator 14 is configured to receive absorbing medium and refrigerant (in its absorbed form) from the vapour-absorption-refrigeration-cycle, and to use heat from the electronic component 12 to evaporate the refrigerant from the absorbing medium, to provide the evaporated refrigerant and absorbing medium back to the vapour-absorption-refrigeration-cycle. Of course, the evaporation process may not be 100% effective, so whilst the evaporated refrigerant output by the generator 14 will be largely free of absorbing medium, and the absorbing medium output by the generator 14 will be largely free of refrigerant, they are not necessarily completely separate.

The housing 16 is a structure surrounding the electronic component 12 and the generator 14. The housing 16 is not necessarily a complete shell, and may have apertures or closable openings allowing the exchange of fluids with the surrounding environment. The housing 16 may be a case, shell, chassis, box or any other rigid structure containing the electronic component 12 and the generator 14. Of course, the electronic device 10 may comprise additional electronic components and apparatus (including connective apparatus) either housed within the housing 16, disposed outside of the housing 16, or disposed partially within and partially without the housing 16.

The form of the generator 14, and the selection of absorbing medium and refrigerant, are implementation specific, and will depend on factors including the heat generation rate of the electronic component 12, the size and shape of the electronic component 12, the range of operating temperatures of the electronic component 12, and the pressure of the refrigerant as received by the generator 14. The generator 14 may include three or more fluid connections, one via which it is configured to receive absorbing medium and absorbed refrigerant, one via which it is configured to provide evaporated refrigerant, and one via which it is configured to provide/return absorbing medium.

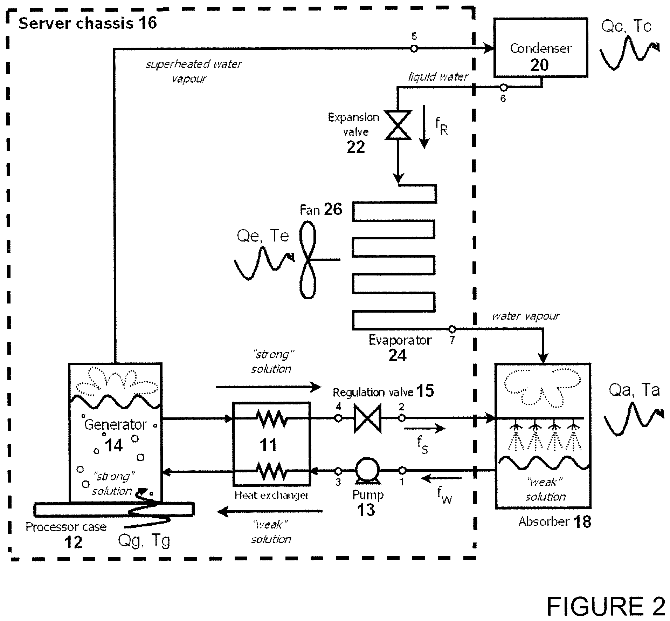

Figure 2 illustrates an embodiment of the present invention in which the electronic device 10 is a server. In the discussion of Figure 2, and Figures 3 and 4, the electronic device 10 is a server and the electronic component 12 is a processor case 12 and its processors. However, the principles discussed are applicable to other embodiments in which the electronic device 10 is other than a server and/or the electronic device 10 is other than a processor case and its processors 12. The curved arrows represent the transfer of energy. The straight arrows to the side of the elements of the cooling cycle represent the direction of fluid flow. Like reference numerals are used across Figures 1 to 4 to denote the equivalence of the elements across the embodiments.

The generator 14 is arranged in contact with a processor case 12 containing a CPU and possibly also ancillary processor chips. The contacting surfaces enable heat transfer from the processor chips to the solution in the generator 14 via conduction, although other arrangements are possible, for example in which there is no direct contact but convection currents and radiation effects transfer heat from the processor chips to the solution. The generator 14 is housed within the server chassis 16. Within the vapour-absorption-refrigeration-cycle, the generator 14 is in fluid communication with the absorber 18 via two channels: a first channel, which includes a pump 13; and a second channel, which includes a regulation valve 15. The regulation valve 15 is exemplary of the fluid pressure decreasing means discussed elsewhere in this document, and the pump 13 is exemplary of the fluid pressure increasing means discussed elsewhere in this document. The generator 14 is also in fluid communication with a condenser 20, via a separate channel from the first and second channels. In this and other embodiments of the present invention, the fluid communication paths/channels may be insulated so that the transfer of fluids is effectively isothermal with the exception of the passage of fluid through elements such as the condenser 20, the evaporator 24, the absorber 18, the heat exchanger 11, and the generator 14.

The condenser 20 is housed outside of the server chassis 16. This is optional, although the removal of heat from within the server is more effective with the condenser 20 outside of the chassis 16. The condenser 20 may be a condenser 20 having two ends: an inlet for receiving fluid; and an outlet for transferring fluid away. However, structurally the condenser 20 may be reversible, so that each end is adapted to function as an inlet or an outlet, and it is their connection within a cooling system that defines the function of each. Alternatively, there may be structural adaptations which predispose one end to functioning as an inlet and the other as an outlet. Within the vapour-absorption-refrigeration-cycle, the inlet of the condenser 20 is in fluid communication with the generator 14, and the outlet is in fluid communication with the evaporator 24, via an expansion valve 22. The expansion valve 22 is exemplary of the condensed refrigerant pressure decreasing means discussed elsewhere in this document. The expansion valve 22 is illustrated within the server chassis 16, however the precise location of the expansion valve 22 is optional, and it may be provided anywhere along the fluid communication path between the condenser 20 and the evaporator 24, and outside or inside the server chassis 16.

The evaporator 24 is disposed within the chassis 16 in the embodiment illustrated in Figure 2, however, since the evaporator 24 removes heat from its surroundings, the evaporator 24 can be disposed in any location from which it is desired to remove heat. In the server example, there is waste heat generated by components other than the processor chips, and some heat from the processor chips not transferred to the solution by the generator 14, which can be removed by the evaporator 24 within the server chassis 16. The server chassis 16 is exemplary of the housing 16 discussed elsewhere in this document. The evaporator 24 may be an evaporator 24 having two ends: an inlet for receiving fluid; and an outlet for transferring fluid away. However, structurally the evaporator 24 may be reversible, so that each end is adapted to function as an inlet or an outlet, and it is their connection within a cooling system that defines the function of each. Alternatively, there may be structural adaptations which predispose one end to functioning as an inlet and the other as an outlet. Within the vapour-absorption-refrigeration-cycle, the inlet of the evaporator 24 is in fluid communication with the condenser 20 via the expansion valve 22, and the outlet is in fluid communication with the absorber 18.

The embodiment of Figure 2 includes a fan 26, which is an optional feature arranged to draw air over the evaporator 24, and around the chassis 16. The location of the fan 26 with respect to the evaporator 24 and the rest of the chassis 16 will depend on implementation details such as the temperature of air being drawn into the chassis 16 by the fan 26, and the temperature within the chassis 16. The fan 26 is configured to facilitate the transfer of waste heat from the chassis 16, and/or components housed therein, to the refrigerant within the evaporator 24, by circulating air as a heat transfer medium.

The absorber 18 is housed outside of the server chassis 16. This is optional, although the removal of heat from within the server is more effective with the absorber 18 outside of the chassis 16. Within the vapour-absorption-refrigeration-cycle, the absorber 18 is in fluid communication with the generator 14 via two channels: a first channel, which includes a pump 13; and a second channel, which includes a regulation valve 15. The generator 14 is also in fluid communication with the evaporator 24, via a separate channel from the first and second channels.

A heat exchanger 11 may be provided to facilitate the exchange of heat between fluid in the first channel and fluid in the second channel. The heat exchanger 11 is optional but may be desirable in some implementations due to thermodynamic considerations. In Figure 2, the heat exchanger 11 is illustrated on the generator 14 side of the pump 13 and regulation valve 15, however, other configurations are possible, for example, either or both of the regulation valve 15 and pump 13 may be provided on the generator 14 side of the heat exchanger 11 along the first and second channels for fluid communication between the absorber 18 and the generator 14.

The refrigerant in the example of Figure 2 is water, and the absorbing medium is a hygroscopic salt solution, which is weakened by mixture with water and strengthened upon boiling of water away from the solution.

The collection of elements: the condenser 20, the expansion valve 22, the evaporator 24, the absorber 18, the pump 13, the regulation valve 15, the heat exchanger 11, the generator 14, the solution, and the refrigerant, and the interconnections between elements, form an exemplary vapour-absorption refrigeration cycle.

The function of each element in the cycle may be demonstrated by consideration of the movement of fluids around the cycle. Taking an arbitrary starting point, a refrigerant in liquid form is received by an expansion valve 22 and allowed to pass through the valve at a flow rate fR. The expansion valve 22 is configured to lower the pressure of the liquid refrigerant it receives, before the refrigerant reaches the evaporator 24. The expansion valve 22 is thus configured to maintain a pressure difference between the refrigerant in the condenser 20 at higher pressure, and the refrigerant in the evaporator 24 at a lower pressure. The expansion valve 22 causes a pressure drop that reduces the pressure of refrigerant received by the evaporator 24 relative to that output by the condenser 20.

The evaporator 24 receives the liquid refrigerant from the expansion valve 22 at a flow rate fR. The evaporator 24 is configured to allow heat transfer from its surroundings to the refrigerant (which has had its pressure lowered by the expansion valve 22 and hence its boiling point reduced), which causes the refrigerant to boil in the evaporator 24 at a temperature Te, removing an amount of heat Qe from the environment surrounding the evaporator 24 in the process. The structure of the evaporator 24 can take a variety of forms, for example, the evaporator 24 may include a coiled pipe of thermally conductive material such as copper which enables heat to transfer from the environment surrounding the pipe to the fluid within the pipe, or it may be provided as a bundle of tubes also of thermally conductive material and having the same effect. The coiling increases the surface area of exposure and hence optimises heat transfer. On leaving the evaporator 24, at least a portion of the refrigerant is in the form of a vapour. The evaporator 24 is configured to allow vaporised refrigerant to escape to the absorber 18, and hence to avoid a build up of vapour pressure and re-condensation of the refrigerant.

As an aside from the cooling cycle, the fan 26 draws or blows air over the evaporator 24, which air is cooled (heat is removed from it and transferred to the refrigerant) and circulated around the chassis 16 to remove heat from components housed therein.

The refrigerant leaves the evaporator 24 and enters the absorber 18, where the absorber 18 is configured to mix the refrigerant with a hygroscopic salt solution. The mixing may be achieved, for example, by a series of sprays in the absorber 18 which are configured to spray solution through the vaporised refrigerant and hence obtain a liquid mixture of refrigerant and solution. Whichever mechanism is used, the absorber 18 is configured to absorb the refrigerant into the solution at a temperature Ta, which condenses the refrigerant and hence releases a certain amount of heat Qa in the absorption process. The solution mixed with refrigerant is referred to as "weak" solution for the purposes of discussion, and the solution from which some or all of the refrigerant has been removed is referred to as "strong" solution. It should be understood that these terms are intended to reflect the relative strengths of the mixture at different points in the cycle, and not to represent any absolute measure of solution strength. However, it will be understood by the skilled reader that there are ranges of solution strengths which are suited to particular implementations.

The pump 13 is configured to pump weak solution at a rate fw through a heat exchanger 11 along the first channel, which connects the absorber 18 and the generator 14.

The generator 14 is configured to harvest heat from the processor case 12 (or other electronic component) to heat the weak solution and hence evaporate the refrigerant from the solution. The harvesting of heat refers to the process of transferring heat from the processor case 12 to the solution, and may be achieved by structural means, such as provision of a thermally conductive medium between the two. A thermally conductive medium may be a metallic plate, and/or water circulated through thermally conductive piping may be used. The refrigerant evaporates from the solution at temperature Tg by virtue of transfer of heat Qg from the electronic device 10 to the liquid mixture of refrigerant and solution. The solution therefore becomes stronger, and is pumped back to the absorber 18 (the effect of the pump 13 in the first channel) via the heat exchanger 11 and a regulation valve 15 which limits the flow rate to fs. The evaporated refrigerant, which may be superheated, is transferred to the condenser 20.

The condenser 20 is configured to transfer heat from the vaporised refrigerant to its surroundings and thus to cause the refrigerant to condense into liquid form. The liquid refrigerant collects and is transferred to the evaporator 24 via the expansion valve 22. The condenser 20 may be liquid cooled, that is to say, the condenser 20 may comprise one or more pipes through which liquid, such as water, is pumped, the water being cooler than the boiling point of the vaporised refrigerant (at the pressure it is received from the generator 14). The vaporised refrigerant is introduced to a chamber surrounding the pipe(s) or otherwise allowed to surround the pipe(s), and hence transfers heat Qc to the water at temperature Tc and condenses on the surface of the pipe(s) and collects in the chamber for transfer to the evaporator 24. Of course, a condenser 20 can be realised by providing surfaces other than pipes carrying water, but the principle of a surface cooled to below the boiling point of the refrigerant in its form at the condenser 20 enables the refrigerant to condense and hence heat Qc to be transferred away.

Overall, in the vapour-absorption-refrigeration-cycle, heat is released as low-grade waste heat at the absorber 18 (amount of heat Qa at temperature Ta) and the condenser 20 (amount of heat Qc at temperature Tc). A controller may be provided which is configured to monitor the temperature in the chassis 16 and set the pump 13 and regulator valve 15 to maintain the boiling point of the refrigerant within the solution at below the normal case temperature of the processors (which may also be monitored). A separate controller may also be provided to monitor the temperature of the environment surrounding the evaporator 24 and to set the expansion valve 22 to maintain the pressure in the refrigerant received by the evaporator 24 to be such that it can boil in the evaporator 24.

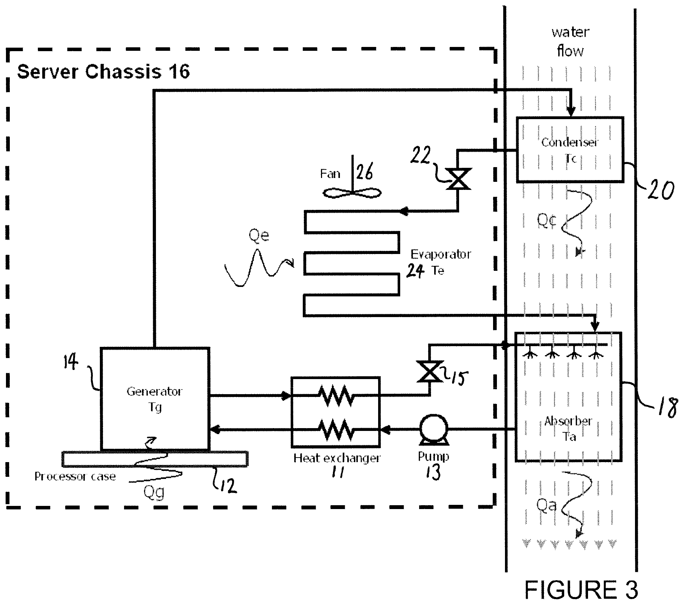

Figure 3 illustrates a particular choice of cooling system to remove heat from the refrigerant at the absorber 18 and condenser 20. A water-based free cooling system is employed to remove low-grade waste heat at the absorber 18 and the condenser 20. Of course, it is not necessary for the same cooling system to be employed at both, and the skilled reader will understand that a water-based free cooling system could be used to remove waste heat from one or the other of the absorber 18 and condenser 20 and not necessarily both. The principle of the water-based free cooling system is that water is circulated through pipes which pass through, in, or around the absorber 18 and condenser 20 in a manner which enables heat to be transferred from the refrigerant and into the piped water. The stream of piped water may then be delivered to a dry cooler or cooling tower.

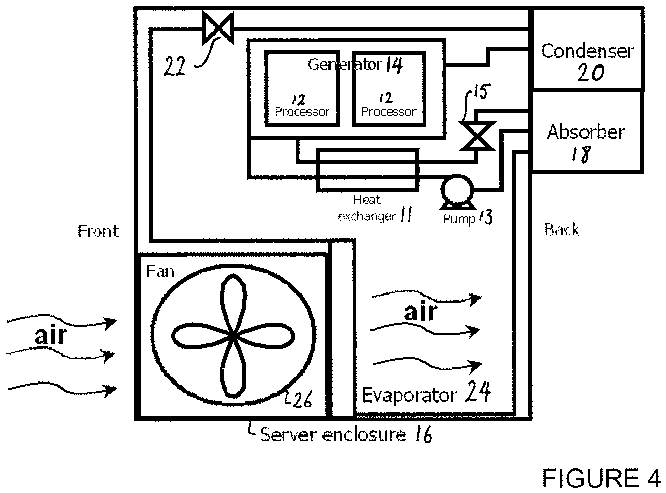

Figure 4 shows a possible embodiment of the invention, depicting the disposition of the elements that compose the vapour-absorption-refrigeration-cycle device within a blade server. The generator 14 is installed over the processors 12, replacing the heat sink. The processors 12 may be within individual cases (not illustrated), within a shared case (not illustrated), or may be provided without a case. The case(s) may be provided of thermally conductive material to facilitate transfer of heat away from the processors. It may be that only the side of the case having a surface facing or contacting the generator 14 is thermally conductive, and the remainder is thermally insulating, to direct heat toward the generator 14 (wherein thermally conductive and thermally insulating may be relative to one another). A generator 14 with a volume of 10 cm x 5 cm x 1 cm (smaller than most heat sinks in blade servers) would be able to contain enough solution to support the solution and refrigerant rates established below in the supporting calculations (fs = 0.379 ml/s, fw = 0.390 ml/s).

Since the temperatures of the absorber 18 and condenser 20 are the same, they can be physically adjacent in the outside of the server; this is the only part of the system that requires removal of waste heat. A fan 26 installed at the front of the server forces outside air through the evaporator 24, thus providing cooling for the server's circuitry.

A feasibility analysis is included as support that embodiments of the invention can be realised and that they have advantageous effects in terms of reducing the load imposed on an external cooling system by an electronic device 10. Furthermore, the feasibility analysis demonstrates how implementing details such as valve pressure settings and solution concentrations can be established, and provides some exemplary parameters which may be used in invention embodiments. Where more than one value of a particular parameter is given in the following analysis, we note that the entire range of values between any two of the more than one value are also feasible parameter values for use in invention embodiments.

In order to demonstrate the feasibility of invention embodiments we will consider a server with a heat dissipation of 300 W, of which 150 W are dissipated by the processor. Therefore, and using the notation employed in Fig. 2, we have Qg = 150 W. The following assumptions will be followed in this analysis:

- We will consider a range of processor case temperature between 60°C and 65°C, well under the maximum case temperature required by most enterprise grade processors.
- The absorption device uses water as a refrigerant and lithium bromide solution as an absorbing medium.
- A heat exchanger with an effectiveness $E_L = 0.7$ will be used; this is a reasonable value that can be improved with careful design.

We will now present the equations that describe the operation of a vapour-absorption-refrigeration cycle (absorption chiller) and use them to demonstrate that the temperature and dissipated power found within servers (as an example of an electronic device) allow the operation of this type of cooling cycle. The sub-indexes in the following expressions are referred to the points identified in Fig. 2.

The concentrations of the strong and weak solutions are estimated using a fit devised by Lansing (F.L. Lansing, "Computer Modeling of a Single-Stage Lithium Bromide/Water Absorption Refrigeration Unit". JPL Deep Space Network Progress Report 42-32, 1976.):

$$X_s = X_2 = \frac{49.04 + 1.125T_g - T_c}{134.65 + 0.47T_g} \quad \text{kg LiBr/kg sol.}$$

$$X_w = X_1 = \frac{49.04 + 1.125T_a - T_e}{134.65 + 0.47T_a} \quad \text{kg LiBr/kg sol.}$$

Both concentration values must satisfy X2 > X1 and $0.5 \leq X_{s,w} \leq 0.65$ kg LiBr/kg solution in order to prevent solution crystallisation. The heat capacities of the strong and weak solutions are then

$$C_s = 1.01 - 1.23X_2 + 0.48X_2^2 \quad \text{kcal/kg}^\circ\text{C}$$

$$C_w = 1.01 - 1.23X_1 + 0.48X_1^2 \quad \text{kcal/kg}^\circ\text{C}$$

The enthalpy of the water leaving the condenser is:

$$H_6 = T_c - 25 \quad \text{kcal/kg}$$

The enthalpy of the saturated water vapour leaving the evaporator is

$$H_7 = 572.8 + 0.417T_e \quad \text{kcal/kg}$$

The enthalpy of the weak solution leaving the absorber is

$$H_1 = 42.81 - 425.92X_1 + 404.67X_1^2 + (1.01 - 1.23X_1 + 0.48X_1^2)T_a \quad \text{kcal/kg}$$

while the enthalpy of the strong solution entering the absorber is

$$H_2 = 42.81 - 425.92X_2 + 404.67X_2^2 + (1.01 - 1.23X_2 + 0.48X_2^2)T_2 \quad \text{kcal/kg}$$

In this expression the temperature T2 is given by

$$T_2 = T_g - E_L(T_g - T_a) \quad {}^\circ\text{C}$$

The enthalpy of the superheated refrigerant vapour leaving the generator is

$$H_5 = 572.8 + 0.46T_g - 0.043T_c \quad \text{kcal/kg}$$

The required refrigerant mass rate is

$$m_R = \frac{Q_e}{H_7 - H_6} \quad \text{kg/hr}$$

The strong and weak solution mass rates can be expressed as

$$m_s = m_R \frac{X_1}{X_2 - X_1} \quad \text{kg/hr}$$

$$m_w = m_R \frac{X_2}{X_2 - X_1} \quad \text{kg/hr}$$

The power required by the generator as well as the amount of heat dissipated in the condenser and the absorber are

$$Q_g = (m_s H_2 + m_R H_5 - m_w H_1) \times 1.1622 \quad \text{W}$$

$$Q_c = m_R(H_5 - H_6) \times 1.1622 \quad \text{W}$$

$$Q_a = (m_s H_2 + m_R H_7 - m_w H_1) \times 1.1622 \quad \text{W}$$

The coefficient of performance for the cooler is

$$COP = \frac{Q_e}{Q_a}$$

The pressures in the evaporator and condenser are

$$P_e = \text{antilog}\left[7.8853 - \frac{1555}{T_e + 273.15} - \frac{11.2414 \times 10^4}{(T_e + 273.15)^2}\right] \quad \text{mmHg}$$

$$P_c = \text{antilog}\left[7.8853 - \frac{1555}{T_c + 273.15} - \frac{11.2414 \times 10^4}{(T_c + 273.15)^2}\right] \quad \text{mmHg}$$

A search procedure was implemented to solve the preceding equations while satisfying the restrictions on solution concentrations, generator temperature, and generator power input; the values produced by this procedure correspond to the highest value of Qe for which a solution exists. Some selected results are shown in Table 1 for Qe = 123 W.

**Table 1:** Results for $E_L = 0.7$, Qe = 123 W.

| Tg (°C) | Tc (°C) | Ta (°C) | Te (°C) | Qg (W) | Qc (W) | Qa (W) | COP | $m_R$ (kg/hr) | $m_s$ (kg/hr) | $m_w$ (kg/hr) |
|---|---|---|---|---|---|---|---|---|---|---|
| 64 | 31 | 31 | 9 | 149.9 | 128.2 | 144.6 | 0.8208 | 0.1854 | 2.0890 | 2.2744 |
| 64.5 | 31.5 | 31.5 | 9.5 | 149.9 | 128.2 | 144.6 | 0.8208 | 0.1855 | 2.0899 | 2.2754 |
| 65 | 31.5 | 31 | 9 | 149.9 | 128.3 | 144.6 | 0.8204 | 0.1855 | 1.9913 | 2.1768 |
| 65 | 32 | 32 | 10 | 149.8 | 128.2 | 144.6 | 0.8208 | 0.1856 | 2.0908 | 2.2763 |

**Table 1** (continuation)

| Pe (mmHg) | Pc (mmHg) | Xs (kg LiBr/kg sol ) | Xw (kg LiBr/kg sol ) |
|---|---|---|---|
| 8.6 | 33.7 | 0.5466 | 0.5020 |
| 8.9 | 34.7 | 0.5462 | 0.5017 |
| 8.6 | 34.7 | 0.5488 | 0.5020 |
| 9.1 | 35.7 | 0.5458 | 0.5013 |

There is a noteworthy aspect about these results: in spite of its low COP, the absorption cooler provides 123 W of cooling power, thus removing 82% of the heat generated by the server's circuitry (excluding of course the heat Qg generated by the processor): therefore, only 27 W need to be removed from the server using conventional forced air cooling. The only additional power needed by the cooling system is the power required to pump solution between the absorber and the generator, which as is demonstrated below is very small. Aside from this pump and the two valves depicted in Fig. 1, the cooler has no other moving parts. The temperature of the evaporator and the amount of heat it absorbs allow its utilisation to cool the air flowing through the server's circuitry.

The mass rate values for refrigerant and solution that have been obtained are all physically realizable values. For instance, from Table 1 we see that with $E_L = 0.7$ and Qe = 123 W one possible operating point is Tg = 65°C, Tc = Ta = 32°C, Te = 10°C; the corresponding solution concentrations are $X_S$ = 0.5458 wt% and $X_W$ = 0.5013 wt%. An approximation to the density of the solution at these concentrations and at a temperature of 25°C is $\rho_1$ = 1532.8 kg/m$^3$ at $X_1$ = 0.499 wt% and $\rho_2$ = 1620.5 kg/m$^3$ at $X_4$ = 0.55 wt% (see Final Report Project 527-RP, "Thermophysical Property Data for Lithium Bromide/Water Solutions at Elevated Temperatures", School of Mechanical Engineering, Georgia Institute of Technology, 1991.). Using these values as well as the density of pure water at 32°C it is found that the volumetric flow rates density of refrigerant and solution are $f_R$ = 0.052 ml/s, $f_s$ = 0.379 ml/s, and $f_w$ = 0.390 ml/s; these are realistic values that can be achieved with little energy consumption. Assuming that copper pipes with a diameter of 2 mm are used (to insure rigidity as well as an appropriate thermal conductivity), the speed of the fluids within the pipes would be 1.6 cm/s, 12 cm/s and 12.4 cm/s for refrigerant, strong solution, and weak solution respectively.

An increase in the effectiveness of the heat exchanger results in a higher COP and consequently a higher cooling capacity Qe; however, an increase of 30% in the efficiency of the heat exchanger results in an increase in Qe of only 6%.

Table 2 shows power and temperature values for selected operating points as the dissipated power fed to the generator is increased from 30 W to 130 W, a situation that corresponds to an increase in server workload and a corresponding increase in processor power. It can be observed that the resulting temperature values and dissipated powers are consistent with the operation of the proposed system, with a COP which is always close to 0.8. It can also be observed that there is little variation in the values of the solution concentration and evaporator and condenser pressures: only the supply rates of refrigerant and solution must be adjusted to reach the desired operation point.

**Table 2:** Results for increasing generator power, $E_L$ = 0.7.

| Qg (W) | Qe (W) | Qc (W) | Qa (W) | Tg (°C) | Tc (°C) | Ta (°C) | Te (°C) | COP |
|---|---|---|---|---|---|---|---|---|
| 30 | 24 | 25 | 29 | 60.5 | 30.5 | 30.5 | 8.5 | 0.7985 |
| 50 | 40 | 41.7 | 48.4 | 63.5 | 31.5 | 31.5 | 8.5 | 0.7984 |
| 70 | 57 | 59.3 | 67.8 | 63.5 | 32 | 32 | 10 | 0.8126 |
| 90 | 74 | 77 | 87 | 65 | 32 | 32 | 10 | 0.8208 |
| 110 | 90 | 93.7 | 106.1 | 64.5 | 32 | 32 | 10 | 0.8185 |
| 130 | 107 | 111.6 | 125.1 | 65 | 31 | 31 | 9 | 0.8244 |

**Table 2** (continuation)

| $m_R$ (kg/hr) | $m_s$ (kg/hr) | $m_w$ (kg/hr) | Pe (mmHg) | Pc (mmHg) | Xs (kg LiBr/kg sol) | Xw (kg LiBr/kg sol) |
|---|---|---|---|---|---|---|
| 0.0362 | 0.6348 | 0.6710 | 8.3 | 32.8 | 0.5310 | 0.5024 |
| 0.0604 | 0.9427 | 1.0030 | 8.3 | 34.7 | 0.5409 | 0.5084 |
| 0.0860 | 1.1787 | 1.2647 | 9.1 | 35.7 | 0.5379 | 0.5013 |
| 0.1116 | 1.2579 | 1.3695 | 9.1 | 35.7 | 0.5458 | 0.5013 |
| 0.1358 | 1.6260 | 1.7618 | 9.1 | 35.7 | 0.5432 | 0.5013 |
| 0.1613 | 1.6256 | 1.7868 | 8.6 | 33.7 | 0.5518 | 0.5020 |

Given the values of temperature and dissipated power associated to the condenser and the absorber, a sensible choice is to employ a water-based free cooling system to remove low grade waste heat. Such an arrangement is depicted in Fig. 3: both the absorber and the condenser release heat into a stream of water which is delivered to a dry cooler or cooling tower. With the condenser and absorber temperatures shown in Tables 1 and 2 as well as a water supply temperature of 29°C the cooling system could be run from a dry cooler for 100% of the time in climates like London's, whereas in warmer places such as Abu Dhabi the use of a cooling tower would allow the system to be run for 100% of the time.

On the other hand, taking into account that COP values hover around 0.8 and assuming that half of the server power is dissipated by the processors, the heat that must still be removed by conventional air cooling is 0.5 x 0.2 = 0.1 or 10% of the power dissipated by the servers. This represents a reduction of 90% in the cooling load and consequently, in the energy consumption of the data centre's cooling system.

Figure 4 shows a possible embodiment of the invention, depicting the disposition of the elements that compose this heat recovery device within a blade server. The generator is installed over the processors, replacing the heat sink. A generator with a volume of 10 cm x 5 cm x 1 cm (smaller than most heat sinks in blade servers) would be able to contain enough solution to support the solution and refrigerant rates previously found (fs = 0.379 ml/s, fw = 0.390 ml/s).

Server power consumption data from SPECPower (http://www.spec.org/power_ssj2008/) tests was used to determine under which conditions the proposed invention could be employed to cool a Fujitsu Primergy server. In order to perform this estimation the processor's thermal design power (TDP) (see Intel Xeon Processor Thermal Design Guidelines, January 2003) was used as a proxy for the maximum power dissipated by the processor Pproc when a 100% load is applied during the SPECPower test (a quantity analogous to Qg); this power is subtracted from the total power Pmax consumed by the server under maximum SPECPower load to determine the power Pserv' = Pmax - Pproc dissipated by the rest of the server, which is analogous to Qe. Waste heat from the processors can be used in the proposed invention if the ratio Pserv'/ Pproc is less or equal than the COP of the absorption device.

The results of the analysis are summarised in Table 3: in all cases it is possible to find an operating point for the cooling cycle subject to the constraints imposed by the processor's TDP and Tcase as well as the cooling load for the rest of the server.

Table 3: Primergy server processor and SPECPower data

| Server | Processor | $P_{proc}$ (W) | Tcase (°C) | $P_{max}$ (W) | $P_{serv}$' (W) | $P_{serv}$'/ $P_{proc}$ |
|---|---|---|---|---|---|---|
| TX150 S6 | X3360 | 95 | 71.4 | 107 | 12 | 0.126 |
| RX100 S5 | L3360 | 95 | 76.3 | 109 | 14 | 0.147 |
| RX100 S5 | X3360 | 95 | 71.4 | 109 | 12 | 0.147 |
| TX150 S7 | X3470 | 95 | 72.7 | 112 | 17 | 0.179 |
| TX150 S7 | X3480 | 95 | 72.7 | 113 | 18 | 0.189 |
| TX140 S1 | E3-1260L | 45 | 58.7 | 53.6 | 9 | 0.191 |
| TX120 S3 | E3-1260L | 45 | 58.7 | 54 | 9 | 0.200 |
| TX150 S6 | X3360 | 95 | 71.4 | 116 | 21 | 0.221 |
| TX300 S6 | 2 x X5670 | 190 | 81.3 | 236 | 46 | 0.242 |
| TX150 S6 | X3220 | 105 | 62.2 | 132 | 27 | 0.257 |
| RX100 S7 | E3-1260L | 45 | 58.7 | 57.2 | 12 | 0.271 |
| RX200 S6 | 2 x X5670 | 190 | 81.3 | 242 | 52 | 0.274 |
| RX300 S6 | 2 x X5670 | 190 | 81.3 | 245 | 55 | 0.289 |
| RX100 S6 | X3480 | 95 | 72.7 | 127 | 32 | 0.334 |
| RX100 S6 | X3470 | 95 | 72.7 | 130 | 35 | 0.368 |
| CX120 S1 | 2 x L5530 | 120 | 70 | 166 | 46 | 0.3833 |
| TX100 S1 | L3360 | 65 | 76.3 | 94.7 | 30 | 0.457 |
| TX150 S6 | L3360 | 65 | 76.3 | 98.4 | 33 | 0.51 |
| RX300 S4 | 2 x E5440 | 160 | 67 | 265 | 105 | 0.656 |
| RX100 S5 | L3360 | 65 | 76.3 | 109 | 44 | 0.677 |
| TX120 | 3070 | 65 | 60.1 | 109 | 44 | 0.677 |

**Claims**

1.  An electronic device (10) comprising:

    a housing (16);
    an electronic component (12) housed within the housing (16); and
    a generator (14) connected to a vapour-absorption-refrigeration-cycle and being housed within the housing (16) and configured to use heat generated by operation of the electronic component to evaporate refrigerant from an absorbing medium in the vapour-absorption-refrigeration-cycle;
an evaporator (24), the evaporator being connected to the vapour-absorption-refrigeration cycle and disposed within the housing;
a condenser (20) and
an absorber (18); whereby the condenser and the absorber are connected to the vapour-absorption-refrigeration-cycle and disposed outside of the housing;
a vapour absorption system being connected to the vapour-absorption-refrigeration-cycle and including the generator (14) and the absorber (18);
wherein the generator (14) and the absorber (18) are in fluid communication with one another via a first channel having a fluid pressure increasing means (13) configured to cause a pressure increase in fluid flowing through the first channel, and a second channel having a fluid pressure decreasing means (15) configured to cause a pressure decrease in fluid flowing through the second channel;
and wherein the absorber (18) is configured to receive the refrigerant from the vapour-absorption-refrigeration-cycle as a vapour, to absorb the refrigerant into an absorbing medium, and to provide the absorbing medium and absorbed refrigerant to the generator (14) via the first channel;
wherein the generator (14) is configured to receive the absorbing medium and absorbed refrigerant, to use heat from the electronic component (12) to evaporate the refrigerant from the absorbing medium, to provide the evaporated refrigerant to the vapour-absorption-refrigeration-cycle, and to provide the absorbing medium to the absorber (18) via the first channel; and **characterized in that** a pressures controller is configured to monitor the temperature of the electronic component (12), and to control the fluid pressure increasing means (13) to set the pressure of the fluid provided to the generator (14) so that the boiling point of the refrigerant in the fluid provided to the generator (14) is below the monitored temperature of the electronic component (12) and within a predetermined margin of said temperature.

2.  An electronic device (10) according to claim 1, further comprising:

    a condensed refrigerant pressure decreasing means (22), connectable within the vapour-absorption-refrigeration cycle, wherein:

        the condenser (20) is configured to receive the evaporated refrigerant from the generator (14) and to transfer heat away from the refrigerant, causing the refrigerant to condense;
        the condensed refrigerant pressure decreasing means (22) is configured to receive the condensed refrigerant from the condenser (20) at a first pressure, and to provide the condensed refrigerant to the evaporator (24) at a second pressure, the second pressure being lower than the first pressure;
        the evaporator (24) is configured to receive the condensed refrigerant provided by the condensed refrigerant pressure decreasing means (22), to use heat from the environment surrounding the evaporator (24) to evaporate the condensed refrigerant, and to provide the refrigerant as a vapour to the absorber (18).

3.  An electronic device (10) according to claim 1, wherein
    the condenser (20) and/or the absorber (18) are configured so that waste heat can be removed from them by a stream of water.

4.  An electronic device (10) according to claim 1, further comprising:

    a fan (26) configured to force air over the evaporator (24).

5.  An electronic device (10) according to any of claims 1 to 4, wherein
    the refrigerant includes water, and the absorbing medium includes hygroscopic salt.

6.  An electronic device (10) according to claim 1, further comprising:

    a heat exchanger (11) configured to transfer heat between fluid flowing through the first channel and fluid flowing through the second channel.

7.  An electronic device (10) according to claim 2, further comprising
    a second pressure controller, configured to monitor the temperature of the environment surrounding the evaporator (24), and to control the condensed refrigerant pressure decreasing means (22) to set the pressure of the condensed refrigerant entering the evaporator (24) so that the boiling point of the condensed refrigerant entering the evaporator (24) is below the monitored temperature of the environment surrounding the evaporator (24) and within a predetermined margin of said temperature.

8. An electronic device (10) according to any of claims 1 to 7, wherein
the electronic device (10) is a server, the housing (16) is a server case, and the electronic component (12) is a processor case containing one or more processors.

9. An electronic device (10) according to claim 8, wherein
the generator (14) is provided as a heat sink for the processor case.

10. A data centre comprising:

an enclosure containing one or more servers according to claim 8 or 9; and
a cooling system configured to remove waste heat from said one or more servers.

**Patentansprüche**

1. Elektronische Vorrichtung (10), umfassend:

ein Gehäuse (16);
ein elektronisches Bauteil (12), das innerhalb des Gehäuses (16) aufgenommen ist; und
einen Generator (14), der mit einem Dampf-Absorption-Kühlung-Kreis verbunden ist und innerhalb des Gehäuses (16) aufgenommen ist und dazu ausgestaltet ist, Wärme, die durch den Betrieb des elektronischen Bauteils erzeugt wird, zu benutzen, um ein Kältemittel aus einem Absorptionsmedium in dem Dampf-Absorption-Kühlung-Kreis zu verdampfen;
einen Verdampfer (24), wobei der Verdampfer mit dem Dampf-Absorption-Kühlung-Kreis verbunden und innerhalb des Gehäuses angeordnet ist;
einen Verflüssiger (20) und
einen Absorber (18);
wobei der Verflüssiger und der Absorber mit dem Dampf-Absorption-Kühlung-Kreis verbunden und außerhalb des Gehäuses angeordnet sind;
ein Dampfabsorptionssystem, das mit dem Dampf-Absorption-Kühlung-Kreis verbunden ist und den Generator (14) und den Absorber (18) umfasst;
wobei der Generator (14) und der Absorber (18) über einen ersten Kanal, der ein Fluiddruckerhöhungsmittel (13) aufweist, das dazu ausgestaltet ist, eine Druckerhöhung in einem Fluid zu bewirken, das durch den ersten Kanal strömt, und einen zweiten Kanal, der ein Fluiddruckminderungsmittel (15) aufweist, das dazu ausgestaltet ist, eine Druckminderung in einem Fluid zu bewirken, das durch den zweiten Kanal strömt, in Fluidverbindung miteinander stehen;
und wobei der Absorber (18) dazu ausgestaltet ist, das Kältemittel aus dem Dampf-Absorption-Kühlung-Kreis als Dampf zu empfangen, das Kältemittel in ein Absorptionsmedium hinein zu absorbieren und das Absorptionsmedium und das absorbierte Kältemittel über den ersten Kanal dem Generator (14) bereitzustellen;
wobei der Generator (14) dazu ausgestaltet ist, das Absorptionsmedium und das absorbierte Kältemittel zu empfangen, Wärme von dem elektronischen Bauteil (12) zu benutzen, um das Kältemittel aus dem Absorptionsmedium zu verdampfen, das verdampfte Kältemittel dem Dampf-Absorption-Kühlung-Kreis bereitzustellen und das Absorptionsmedium über den ersten Kanal dem Absorber (18) bereitzustellen; und
**dadurch gekennzeichnet, dass** eine Drucksteuerung dazu ausgestaltet ist, die Temperatur des elektronischen Bauteils (12) zu überwachen und das Fluiddruckerhöhungsmittel (13) so zu steuern, dass es den Druck des Fluids, das dem Generator (14) bereitgestellt wird, derart einstellt, dass der Siedepunkt des Kältemittels in dem Fluid, das dem Generator (14) bereitgestellt wird, unterhalb der überwachten Temperatur des elektronischen Bauteils (12) und innerhalb einer vorgegebenen Spanne dieser Temperatur liegt.

2. Elektronische Vorrichtung (10) nach Anspruch 1, ferner umfassend:

ein den Druck des verflüssigten Kältemittels minderndes Mittel (22), das innerhalb des Dampf-Absorption-Kühlung-Kreises einbindbar ist, wobei:

der Verflüssiger (20) dazu ausgestaltet ist, das verdampfte Kältemittel von dem Generator (14) zu empfangen und Wärme von dem Kältemittel abzuführen, was bewirkt, dass das Kältemittel sich verflüssigt; das den Druck des verflüssigten Kältemittels mindernde Mittel (22) dazu ausgestaltet ist, das verflüssigte Kältemittel von dem Verflüssiger (20) mit einem ersten Druck zu empfangen und das verflüssigte Kältemittel dem Verdampfer (24) mit einem zweiten Druck bereitzustellen, wobei der zweite Druck niedriger ist als der erste Druck; der Verdampfer (24) dazu ausgestaltet ist, das verflüssigte Kältemittel zu empfangen, das durch das den Druck des verflüssigten Kältemittels mindernde Mittel (22) bereitgestellt wird, Wärme aus der Umgebung, die den Verdampfer (24) umgibt, zu benutzen, um das verflüssigte Kältemittel zu verdampfen, und das Kältemittel als Dampf dem Absorber (18) bereitzustellen.

3. Elektronische Vorrichtung (10) nach Anspruch 1, wobei der Verflüssiger (20) und/oder der Absorber (18) derart ausgestaltet sind, dass Abwärme von ihnen durch einen Wasserstrom abgeführt werden kann.

4. Elektronische Vorrichtung (10) nach Anspruch 1, ferner umfassend:

einen Lüfter (26), der dazu ausgestaltet ist, Luft über den Verdampfer (24) hinweg zu bewegen.

5. Elektronische Vorrichtung (10) nach einem der Ansprüche 1 bis 4, wobei das Kältemittel Wasser umfasst und das Absorptionsmedium ein hygroskopisches Salz umfasst.

6. Elektronische Vorrichtung (10) nach Anspruch 1, ferner umfassend:

einen Wärmetauscher (11), der dazu ausgestaltet ist, Wärme zwischen Fluid, das durch den ersten Kanal strömt, und Fluid, das durch den zweiten Kanal strömt, zu übertragen.

7. Elektronische Vorrichtung (10) nach Anspruch 2, ferner umfassend:

eine zweite Drucksteuerung, die dazu ausgestaltet ist, die Temperatur der Umgebung zu überwachen, die den Verdampfer (24) umgibt, und das den Druck des verflüssigten Kältemittels mindernde Mittel (22) so zu steuern, dass es den Druck des verflüssigten Kältemittels, das in den Verdampfer (24) gelangt, derart steuert, dass der Siedepunkt des verflüssigten Kältemittels, das in den Verdampfer (24) gelangt, unterhalb der überwachten Temperatur der Umgebung, die den Verdampfer (24) umgibt, und innerhalb einer vorgegebenen Spanne dieser Temperatur liegt.

8. Elektronische Vorrichtung (10) nach einem der Ansprüche 1 bis 7, wobei die elektronische Vorrichtung (10) ein Server ist, das Gehäuse (16) ein Servergehäuse ist und das elektronische Bauteil (12) ein Prozessorgehäuse ist, das einen oder mehrere Prozessoren enthält.

9. Elektronische Vorrichtung (10) nach Anspruch 8, wobei der Generator (14) als Wärmesenke für das Prozessorgehäuse vorgesehen ist.

10. Datenzentrum, umfassend:

eine Ummantelung, die einen oder mehrere Server nach Anspruch 8 oder 9 enthält; und ein Kühlsystem, das dazu ausgestaltet ist, Abwärme von dem einen oder den mehreren Servern abzuführen.

**Revendications**

1. Dispositif électronique (10) comprenant :

une enceinte (16) ; un composant électronique (12) logé dans l'enceinte (16) ; et un générateur (14) connecté à un cycle vapeur-absorption-réfrigération et qui est logé dans l'enceinte (16) et configuré pour utiliser de la chaleur générée par le fonctionnement du composant électronique pour faire évaporer un réfrigérant à partir d'un milieu absorbant dans le cycle vapeur-absorption-réfrigération ; un évaporateur (24), l'évaporateur étant connecté au cycle vapeur-absorption-réfrigération et disposé dans l'enceinte ;

un condenseur (20) et

un absorbeur (18) ;

dans lequel le condenseur et l'absorbeur sont connectés au cycle vapeur-absorption-réfrigération et disposés à l'extérieur du enceinte ;

un système d'absorption de vapeur étant connecté au cycle vapeur-absorption-réfrigération et comprenant le générateur (14) et l'absorbeur (18) ;

dans lequel le générateur (14) et l'absorbeur (18) sont en communication fluidique l'un et l'autre via un premier canal ayant des moyens d'augmentation de pression de fluide (13) configurés pour provoquer une augmentation de pression dans le fluide s'écoulant à travers le premier canal, et un second canal ayant des moyens de diminution de pression de fluide (15) configurés pour provoquer une diminution de pression dans le fluide s'écoulant à travers le second canal ;

et dans lequel l'absorbeur (18) est configuré pour recevoir le réfrigérant du cycle vapeur-absorption-réfrigération sous forme de vapeur, pour absorber le réfrigérant dans un milieu absorbant, et pour fournir le milieu absorbant et le réfrigérant absorbé au générateur (14) via le premier canal ;

dans lequel le générateur (14) est configuré pour recevoir le milieu absorbant et le réfrigérant absorbé, pour utiliser de la chaleur provenant du composant électronique (12) pour faire évaporer le réfrigérant à partir du milieu absorbant, pour fournir le réfrigérant évaporé au cycle vapeur-absorption-réfrigération, et pour fournir le milieu absorbant à l'absorbeur (18) via le premier canal ; et

**caractérisé en ce qu'**un dispositif de commande de pression est configuré pour surveiller la température du composant l'électronique (12), et pour commander les moyens d'augmentation de pression de fluide (13) afin d'établir la pression du fluide fourni au générateur (14) de sorte que le point d'ébullition du réfrigérant dans le fluide fourni au générateur (14) est inférieur à la température surveillée du composant électronique (12) et dans une marge prédéterminée de ladite température.

2. Dispositif électronique (10) selon la revendication 1, comprenant en outre :

des moyens de diminution de pression de réfrigérant condensé (22), pouvant être connectés dans le cycle vapeur-absorption-réfrigération, dans lequel :

le condenseur (20) est configuré pour recevoir le réfrigérant évaporé provenant du générateur (14) et pour transférer la chaleur au loin du réfrigérant, entraînant la condensation du réfrigérant ;

les moyens de diminution de pression de réfrigérant condensé (22) sont configurés pour recevoir le réfrigérant condensé provenant du condenseur (20) à une première pression, et pour fournir le réfrigérant condensé à l'évaporateur (24) à une seconde pression, la seconde pression étant inférieure à la première pression ;

l'évaporateur (24) est configuré pour recevoir le réfrigérant condensé fourni par les moyens de diminution de pression de réfrigérant condensé (22), pour utiliser de la chaleur provenant de l'environnement entourant l'évaporateur (24) pour faire évaporer le réfrigérant condensé, et pour fournir le réfrigérant sous forme de vapeur à l'absorbeur (18).

3. Dispositif électronique (10) selon la revendication 1, dans lequel
le condenseur (20) et/ou l'absorbeur (18) sont configurés de sorte que de la chaleur perdue peut être retirée de ceux-ci par un courant d'eau.

4. Dispositif électronique (10) selon la revendication 1, comprenant en outre :

un ventilateur (26) configuré pour pousser de l'air au-dessus de l'évaporateur (24).

5. Dispositif électronique (10) selon l'une quelconque des revendications 1 à 4, dans lequel
le réfrigérant comprend de l'eau, et le milieu absorbant comprend un sel hygroscopique.

6. Dispositif électronique (10) selon la revendication 1, comprenant en outre :

un échangeur de chaleur (11) configuré pour transférer de la chaleur entre un fluide s'écoulant à travers le premier canal et un fluide s'écoulant à travers le second canal.

7. Dispositif électronique (10) selon la revendication 2, comprenant en outre

un second dispositif de commande de pression, configuré pour surveiller la température de l'environnement entourant l'évaporateur (24), et pour commander les moyens de diminution de pression de réfrigérant condensé (22) pour établir la pression du réfrigérant condensé entrant dans l'évaporateur (24) de sorte que le point d'ébullition du réfrigérant condensé entrant dans l'évaporateur (24) est inférieur à la température surveillée de l'environnement entourant l'évaporateur (24) et dans une marge prédéterminée de ladite température.

**8.** Dispositif électronique (10) selon l'une quelconque des revendications 1 à 7, dans lequel
le dispositif électronique (10) est un serveur, l'enceinte (16) est un boîtier de serveur, et le composant électronique (12) est un boîtier de processeur contenant un ou plusieurs processeurs.

**9.** Dispositif électronique (10) selon la revendication 8, dans lequel
le générateur (14) est fourni sous forme d'un dissipateur de chaleur pour le boîtier de processeur.

**10.** Centre de données comprenant :

une enceinte contenant un ou plusieurs serveurs selon la revendication 8 ou 9 ; et
un système de refroidissement configuré pour extraire de la chaleur perdue à partir desdits un ou plusieurs serveurs.

FIGURE 1

FIGURE 2

FIGURE 3

FIGURE 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7394655 B1
- US 20050076660 A1
- US 20100175851 A1
- DE 3740357 A1

### Non-patent literature cited in the description

- **F.L. LANSING.** Computer Modeling of a Single-Stage Lithium Bromide/Water Absorption Refrigeration Unit. *JPL Deep Space Network Progress Report,* 1976, 42-32
- Thermophysical Property Data for Lithium Bromide/Water Solutions at Elevated Temperatures. School of Mechanical Engineering. Georgia Institute of Technology, 1991
- *Intel Xeon Processor Thermal Design Guidelines,* January 2003